# EUROPEAN PATENT APPLICATION

(11) **EP 4 730 394 A1**
(43) Date of publication of application: **22.04.2026**
(21) Application number: 24822883.5
(22) Date of filing: 10.06.2024
(51) Int. Cl.: H01L 21/36, H01L 29/16

(54) **INTERDIGITATED DIAMOND JUNCTION FIELD-EFFECT TRANSISTOR (INTERJFET) AND METHOD FOR MANUFACTURING SAME**

(30) Priority: 13.06.2023 ES 202330494
(71) Applicant: Universidad de Cádiz, 11003 Cádiz (ES)
(72) Inventor: ARAUJO GAY, Daniel, 11519 Puerto Real Cádiz (ES); CAÑAS FERNÁNDEZ, Jesús, 11519 Puerto Real Cádiz (ES); LLORET VIEIRA, Fernando, 11519 Puerto Real Cádiz (ES); VILLAR CASTRO, María del Pilar, 11519 Puerto Real Cádiz (ES)
(74) Representative: Herrero & Asociados, S.L.
(86) International application number: PCT/ES2024/070359
(87) International publication number: WO 2024/256738

(57) **Abstract**

The present invention consists of a junction field-effect transistor (JFET) for high-power electronics using lateral/selective diamond growth, based on an interdigitated geometry, InterJFET.

This is an original approach, a vertically oriented and interdigitated depletion FET (field-effect transistor), InterJFET.

The manufacturing method incorporates original diamond growth solutions, such as selective and lateral growth. This device enables high drain currents (16-32 A at 10 V bias on 4x4 mm² substrates) thanks to its interdigitated architecture, which maximizes channel density per substrate area. Furthermore, this architecture can operate at voltages up to 3 kV and temperatures exceeding 250°C.

## Description

### TECHNICAL SECTOR

Industrial sector: Energy.

### BACKGROUND OF THE INVENTION

In a context of widespread concern about the energy-environment conflict, an extraordinary increase in electricity use is expected for energy production, transport, and consumption. New power electronics (PE) energy conversion systems will enable enormous energy savings and significant improvements in quality of life. All energy-consuming devices, from pacemakers and household appliances to electric vehicles and industrial waste processing plants, will be affected. All alternative, sustainable, and distributed energy sources, as well as energy storage systems, will be linked to a smart grid through fast and efficient PE converters.

In applications where society demands increasingly efficient and optimized electrical energy conversion (low-carbon renewable energy, transportation energy, and smart grids), the impact of power electronics is remarkable. Approximately 30% of all generated electricity uses power electronics at some point between generation and end use. PE is used for more efficient transport, production and distribution of renewable energy, including the distribution of electricity over long distances through high-voltage direct current (HVDC) power lines, as well as for better control of loads in switched-mode power supplies and variable speed drives in fan motors, pumps and compressors. By 2030, it is expected that up to 80% of all electricity will use power electronics at some point between generation and consumption. However, with the current state of electrical equipment, the transformation of electrical energy involves significant losses (for example, 9% in Spain from the source to the point of use). This is because the available semiconductors are not ideal for these high power levels.

Silicon is a well-established semiconductor material that has addressed power conversion requirements for over 50 years. However, it is widely known (as can be seen in *Research roadmaps on power semiconductor devices* [1]) that the use of devices based on wide-bandgap (WBG) semiconductor materials would result in a real improvement in power electronics. These materials have electrical features far superior to those of silicon for power device applications. Many network applications, for example for the 320 kV HVDC network, use multilevel converters, with 3.3 kV (and 6.5 kV) silicon power semiconductors in series for each required voltage level. To achieve a high-level current, the devices must be connected in parallel. WBG-based power electronics will lead to substantial improvements in the performance of power electronic systems by offering higher blocking voltages, and better efficiency and reliability (higher performance/cost ratio), as well as easier parallel connection, and lower thermal requirements, it enables more efficient and environmentally friendly electronic systems. For a decade, companies such as ABB, Mitsubishi, and Toshiba have been using Si IGBTs or SiC MOSFETs (e.g., Infineon, MOS: metal-oxide-semiconductor FETs). These systems currently reach 6.5 kV, and the next step is to reach 13 kV for HVDC converters. At this point, diamond may be the only material capable of achieving such tensile strength, as shown in Table 1. In addition to its high tensile strength, diamond is also highly tolerant to "high power density," which is highly desirable for ultra-high-power devices.

**Table 1: The properties of diamond are surprisingly superior to those of other semiconductors when considering its use in power electronic devices. The Johnson Figure of Merit (FoM) is a measure of the ultimate performance of a transistor at high power and high frequency; the Keyes FoM measures the performance limited by heat generation and dissipation; and the Baliga FoM measures the performance limited by losses in high power and high frequency operation. The properties/figures in which diamond excels for the present invention are highlighted in red.**

| **Property (unit)** | **Si** | **SiC-4H** | **GaN** | **Ga₂O₃** | **Diamond** |
|---|---|---|---|---|---|
| Wide-bandgap (eV) | 1.1 | 3.23 | 3.42 | 4.8 | ***5*.*45*** |
| Dielectric constant, ε | 11.8 | 9.7 | 9 | 10 | 5,7 |
| Breakdown field (MV/cm) | 0.3 | 3 | 2 | 8 | ***10*** |
| Electron mobility (cm²/Vs) | 1500 | 1000 | ***2000*** | 300 | 1000 |
| Hole mobility (cm²/Vs) | 480 | 100 | 20 | | ***2000*** |
| Thermal conductivity (W/cmK) | 1.5 | 5 | 1.5 | 0.27 | ***22*** |
| Johnson FoM (10²³ ΩW/s²) | 2.3 | 900 | 490 | 1236 | ***2530*** |
| Keyes FoM (10⁷ W/Ks) | 10 | 53 | 17 | 2 | ***218*** |
| Baliga FoM (Normalized to Si) | 1 | 554 | 188 | 3214 | ***23068*** |

Due to its exceptional properties [2], diamond is considered among all WBG semiconductors to be the ultimate semiconductor for high-power electronics applications. Its dielectric breakdown resistance is 3 times greater than that of silicon carbide (SiC) and more than 30 times greater than that of silicon (Si). Furthermore, unlike most other WBG semiconductors, the mobility of both carrier types is very high and its thermal conductivity is unsurpassed (see Table 1). This has led to its use in industry where, in 1995, a diamond FET using a table-like architecture was patented [3]. The transistor uses a substrate on which diamond is heteroepitaxially grown. Although the device is said to be made with monocrystalline or polycrystalline diamond, it is currently not possible to grow monocrystalline diamond on substrates that are not also monocrystalline diamond. This is because small differences in lattice parameters between the substrate and the diamond layer result in an extremely high defect density. Furthermore, the grain boundaries of polycrystalline diamond have high graphite content and act as electrical pathways, short-circuiting the device.

Three decades later, a three-dimensional MOSFET was patented, whose manufacturing method allows it to be made entirely of monocrystalline diamond [4]. This design takes into account the possible existence of crystalline defects, thus resolving one of the main problems with these devices. However, it does not address other equally important technological issues. In diamond MOSFETs, to date, inversion has only very recently been demonstrated on the (111) oriented diamond surface [4], whereas accumulation has been obtained with the oxygen-terminated diamond surface when SiO₂ is deposited. The main problem is the oxide/diamond configuration where interface states can fix the Fermi level and prevent the formation of a 2D carrier gas (2DG) due to an unsuitable band configuration at the interface. This problem is not simple; the type of growth (3D or 2D), miscutting of the substrate, and many other factors can alter the "free" bonds at the interface and modify Fermi-level pinning. Therefore, controlling diamond/oxide structures capable of generating 2DG is not currently feasible, and consequently, a diamond MOSFET cannot currently meet the requirements that society needs.

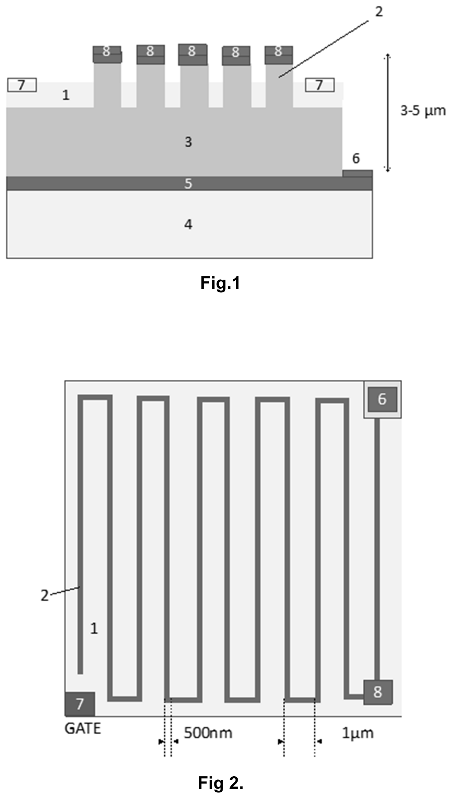

Consequently, this invention presents an alternative, much more effective approach. Figure 1 describes the structure of the invention, which is based on several technological steps for its manufacture: (i) growth of p-type diamonds [6], (ii) growth of n-type diamonds [7], (iii) lateral or selective growth [8], (iv) fabrication of contacts [9] and ICP etching of the diamond [10], (v) electrical characterization [11], (vi) structural characterization [12], (vii) doping evaluation [13], band gap [14], and band adjustment [15]. Furthermore, control of growth parameters such as doping level, improper cutting, etc., is required to achieve high-quality homoepitaxial diamond layers [16].

### DESCRIPTION OF THE INVENTION

In this context, the present invention comprises a diamond-based transistor device and its manufacturing method. It is an original approach: a vertically oriented, interdigitated, depleted FET (field-effect transistor), or InterJFET. The manufacturing method incorporates novel diamond growth solutions, such as selective and lateral growth. This device enables high drain currents (16-32 A at 10 V bias on 4 x 4 mm² substrates) thanks to its interdigitated architecture, which maximizes the channel density per substrate area. Furthermore, this architecture can operate at voltages up to 3 kV and temperatures exceeding 250°C.

The invention utilizes a vertical architecture that allows for increased drain current density and dielectric breakdown voltage compared to lateral devices [17]. It is a novel device, being a vertical diamond transistor with bulk conduction. Only one other example of a diamond MOSFET with surface conduction and a vertical architecture (which allows for increased total current) is known [18][19], and in this case, it operates in inverting mode, 2DG. Furthermore, the p-n junction of the invention enables the "Normally OFF" state of the JFET, whereas those reported in the literature are "Normally ON," which makes them unstable due to the concept of H-termination (current fluctuations in ON mode).

As mentioned, to achieve a "Normally OFF" state, a p-n junction is used to close the vertical channel. Using a Schottky junction would not be technically feasible since metal deposition on vertical surfaces is not technically possible. The problem of vertical deposition between the digits is solved by MPCVD (microwave plasma-assisted chemical vapor deposition) growth of an n-doped layer that generates a depleted zone. Indeed, MPCVD diamond growth from an n-type layer can be easily done in two ways: (i) by a selective growth step or (ii) by lateral growth. This layer allows, on the one hand, an increase in current in the ON state and, on the other hand, an increase in voltage resistance (a p-n junction is more resistant than a Schottky contact), allowing it to work at higher power levels. Adjusting the doping levels is crucial for correctly sizing the depleted and drift zones, avoiding punch-through if possible. The proposed design (Figures 1 and 2) allows for a voltage greater than 1 kV.

Furthermore, to achieve a very high density of vertical interfaces, that is, to maximize the total current per substrate area, the design features an interdigitated concept, made possible only by its vertical architecture. This allows for currents of 30-100 A per 4 mm x 4 mm substrate. The standardized resistance for each device is 3 mΩ cm². This value is similar to the best values obtained for H-terminated vertical FETs.

### BRIEF DESCRIPTION OF THE DRAWINGS

**Figure 1****:** Schematic cross-sectional description of the InterJFET of the invention. A p⁺ doped layer (5) is grown on the substrate (4), on which the drain ohmic contact (6) will be manufactured. The selective growth of MPCVD allows the growth of the p-doped regions of the device (3), as well as the n-doped regions (1). The source (8) and gate (7) contacts will be fabricated on these, respectively. Alternatives to selective growth are considered (see section "Embodiment of the Invention"). The Normally OFF state is achieved thanks to the depleted area of the p-n junction. It can be seen that critical dimensions such as the depth and width of the interdigits make laser photolithography difficult. Therefore, electrolithography and/or FIB nanomachining must be used.
**Figure 2****:** Schematic description from above (top view) of the entire substrate revealing the interdigitated structure. The drain (6), source (8), and gate (7) contacts are marked. The gate laterally closes the channel on both sides (1) with a p-doped vertical channel (2). The relative dimensions and sizes are not shown (see, for example, the sizes between digits).

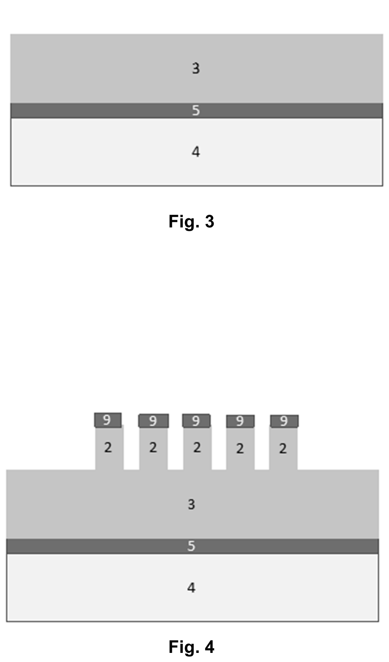

**Figure 3****:** First method of device manufacturing. Growth on the substrate (4) of the bilayer formed by a highly doped p, p⁺ type layer (5), followed by a low doped p, p⁻type layer (3).
**Figure 4****:** Manufacturing method of the interdigitated structure (2) formed by a first layer with low p, p⁻ type doping, (3) followed by a highly p, p⁺ type doped layer (9). The manufacture of this structure can be carried out by two alternative methods:
   Option A: Selective growth, using a Ti mask, of a p-/p+ structure (2 and 9) on the first p+/p- bilayer (5 and 3).
   Option B: Growth of a p+ layer (9) on the previously grown p+/p- bilayer (5 and 3) and subsequent nanomachining using a focused ion beam microscope (FIB), or by inductively coupled plasma (ICP) etching and electrolithography, on the p-/p+ layers to generate the "columns" (2 and 9, the interdigits).

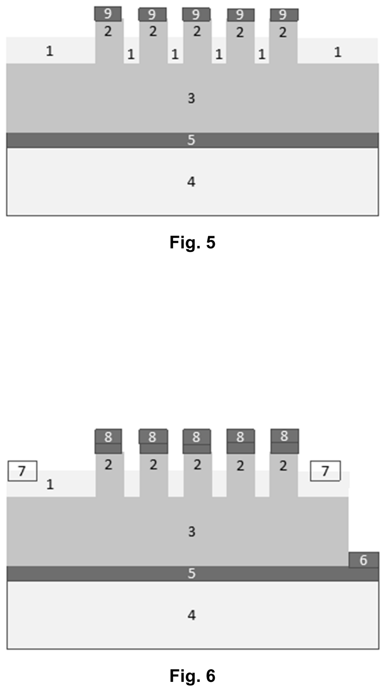

**Figure 5****:** n-type layer manufacturing method (1). An n-type diamond layer is grown by selective growth (with a Ti mask and electrolithography before growth).
**Figure 6****:** Contact manufacture. The drain (6), source (8), and gate (7) contacts are manufactured on the structure. The gate contact is manufactured directly on the n-type doped layer (1). The source contact must be fabricated on the interdigitations (2). Finally, to fabricate the drain contact, the structure must be etched at one end until it contacts the first of the grown p⁺ type doped layers (5). The contact manufacturing method can be carried out using electrolithography and PVD, ICP, or FIB.

### PREFERRED EMBODIMENT OF THE INVENTION

The invention consists of a junction field-effect transistor (JFET) for high-power electronics obtained by lateral/selective diamond growth, based on an interdigitated geometry.

The JFET that is the subject of the invention comprises:
a) An electronic-grade and suitably polished diamond substrate (surface roughness ≤1 nm).
b) A first layer of highly doped p+ type semiconductor diamond material.
c) A second layer of p-type low-doped diamond material -.
d) A third layer of p-type doped low diamond consisting of a digitated structure.
e) A fourth layer of highly doped p+ type diamond that vertically continues the previous digitated structure.
f) A fifth layer of n-type doped semiconductor diamond material grown on the slopes of each digitated structure of the previous layer.
g) Engraved at their ends, deep enough to reach the first layer of p+ type semiconductor diamond.

Some features of the JFET are the following:
- It uses monocrystalline diamond as both substrate and active material.
- The second p⁻ diamond layer has an etched surface, exhibiting an interdigitated structure.
- The first p⁺ semiconducting diamond layer has a boron concentration in the range of 10¹⁷<[B]<10²⁴ cm⁻³.
- Its second and third p⁻ diamond layers have a boron concentration in the range of 10¹⁵<[B]<10¹⁷cm⁻³.
- Its fourth p⁺ semiconducting diamond layer has a boron concentration in the range of 10¹⁷<[B]<10²⁴ cm⁻³.
- Its fifth n-doped diamond layer is deposited in the spacing between the p-/p+ diamond digits.

Their drain contacts are made on the first p⁺ type diamond layer, the source contacts are made on the digits of the last p+ diamond layer, and the gate contacts are made on the n-type diamond layer, but in none of the cases do they have to be limited to occupying those layers.

Below, a preferred embodiment of the object of the invention developed is described.

A highly doped p-type layer (p⁺ layer) is grown on a high-quality, low-roughness commercial diamond substrate (electron grade and finely polished). This is achieved by doping the diamond with boron. On top of this highly doped layer, which acts as the drain contact, another layer with low doping (p⁻ layer) is grown, which acts as the drift layer. The drain contact requires a B doping level of 10¹⁹-10²⁰ cm⁻³ to have an ohmic character with low contact resistance, while the drift layer grown on top requires doping levels of around 1-3 x 10¹⁶ cm⁻³. Therefore, the growth must be carried out in separate reactors or by changing the quartz tube of the MPCVD chamber between the growths of both layers.

Two equally valid options are proposed for the manufacturing of the interdigits:
Option A: Selective growth, using a Ti mask, of a p⁻/p⁺ structure on the first p⁺/p⁻ bilayer.
Option B: Growth of a p⁺ layer on the previously grown p⁺/p⁻ bilayer and subsequent nanomachining with a focused ion beam microscope (FIB), or by inductively coupled plasma (ICP) attack and electrolithography, on the p⁻/p⁺ layers for the generation of the "columns" (the interdigits).

Once the interdigits of any of the proposed options are manufactured, an n-type doped layer is selectively grown, which can be doped with nitrogen or phosphorus (using a Ti mask and electrolithography before growth). This layer generates an SCR that will close the channel for the Normally-OFF state. Because the doping must be n-type, this growth must be carried out in a different reactor than the one used for boron doping, to ensure that there is no cross-contamination.

The drain, source, and gate contacts are manufactured on this structure. The gate contact is manufactured directly on the n-type doped layer. The source contact must be manufactured on the interdigitations. Finally, to fabricate the drain contact, the structure must be etched at one end until it contacts the first of the grown p⁺ type doped layers. The contact manufacturing process can be carried out using electrolithography and PVD, ICP, or FIB.

It should be noted that, due to the requirement of having very narrow spacing (to achieve the Normally OFF state with p-doped atoms of 2 x 10¹⁶ cm⁻³, a space between digits of 2-3 µm is required), it is necessary to use electrolithography that provides accuracy in the nm range.

### References

[1] H. Ohashi, Proceedings of the 24th ISPSD 3-7 June 2012, Bruges, Belgium.
[2] D. Araujo, M. Suzuki, F. Lloret, G. Alba and P. Villar, Diamond for Electronics: Materials, Processing and Devices, Materials 14, 7081 (2021). https://doi.org/10.3390/ma14227081.
[3] D. L. Dreifus, patente JPH06177400A, Kobe Steel LTD, 1994
[4] F. Lloret, D. Araujo, P. Godignon, D. Eon, J. Pernot, E. Bustarret, Patente ES2763702A1, Universidad de Cádiz, CSIC, 2020.
[5] T. Matsumoto, H. Kato, T. Makino, M. Ogura, D. Takeuchi, S. Yamasaki, T. Inokuma and N. Tokuda, Inversion channel mobility and interface state density of diamond MOSFET using N-type body with various phosphorus concentrations, Appl. Phys. Lett. 114, 242101 (2019).
[6] F. Lloret, A. Fiori, D. Araujo, D. Eon, M. P. Villar, and E. Bustarret, Stratigraphy of a diamond epitaxial three-dimensional overgrowth using doping superlattices, Appl. Phys. Lett. 108, 181901 (2016) // R. Rouzbahani, Sh. S. Nicley, D. E.P. Vanpoucke, F. Lloret, P. Pobedinskas, D. Araujo, K. Haenen, Impact of methane concentration on surface morphology and boron incorporation of heavily boron-doped single crystal diamond layers, Carbon 172, 463 (2021)
[7] S. Koizumi, M. Suzuki, n-type doping of diamond, Phys. Stat. Sol. A 203, 3358 (2006) // F. Lloret, B. Soto, R. Rouzbahani, M. Gutierrez, K. Haenen, D. Araujo, "High phosphorous incorporation in (100)-oriented MP CVD diamond growth", Diamond & Related Materials 133, 109746 (2023)
[8] F. Lloret, D. Eon, E. Bustarret, F. Donatini, and D. Araujo, Selectively boron doped homoepitaxial diamond growth for power device applications, Appl. Phys. Lett. 118, 023504 (2021); https://doi.org/10.1063/5.0031478 .
[9] G. Alba, D. Leinen, M.P. Villar, R. Alcántara, J.C. Piñero, A. Fiori, T. Teraji, D. Araujo, Comprehensive nanoscopic analysis of tungsten carbide/Oxygenated-diamond contacts for Schottky barrier diodes, Appl. Surf. Sci. 537, 147874 (2021), https://doi.org/10.1016/j.apsusc.2020.147874 .
[10] B. Soto, J. Cañas, M.P. Villar, D. Araujo and J. Pernot. Transport mechanism in O-terminated diamond/ZrO2 based MOSCAPs, Diam. Rel. Mater 121, 108745 (2021), https://doi.org/10.1016/j.diamond.2021.108745 //
[11] T. T. Pham, J. C. Piñero, A. Maréchal, M. Gutiérrez, F. Lloret, D. Eon, E. Gheeraert, N. Rouger, D. Araújo and J. Pernot, Impact of Nonhomoepitaxial Defects in Depleted Diamond MOS Capacitors, IEEE Trans. On Electr. Dev. 65, 1830 (2018) // M. Suzuki, T. Sakai, T. Makino, H. Kato. D. Takeuchi, M. Ogura, H. Okushi and S. Yamasaki, "Electrical characteristics of 5 kV PiN diodes", Proceedings of Hasselt Diamond Workshop 2014, p.71. See also: M. Suzuki, "High voltage diamond pin diodes". Oyo Buturi 85, 218 (2016).
[12] M. P. Alegre, D. Araújo, A. Fiori, J. C. Pinero, F. Lloret, M. P. Villar, P. Achatz, G. Chicot, E. Bustarret, and F. Jomard, Critical boron-doping levels for generation of dislocations in synthetic diamond, Appl. Phys. Lett. 105, 173103 (2014); doi: 10.1063/1.4900741
[13] D. Araujo, M.P. Alegre, A. Garcia, P. Villar, E. Bustarret, Ph. Achatz, P.N. Volpe, F. Omnès, Phys. Stat. Sol. (c) 8, 1366 (2011) / DOI 10.1002/pssc.201083991 // D. Araujo, M.P. Alegre, A. Garcia, P. Villar, E. Bustarret, Ph. Achatz, P.N. Volpe, F. Omnès, Phys. Stat. Sol. (c) 8, 1366 (2011) / DOI 10.1002/pssc.201083991
[14] J. Cañas, J.C. Piñero, F. Lloret, M. Gutierrez, T. Pham, J. Pernot, D. Araujo, Determination of alumina bandgap and dielectric functions of diamond MOS by STEM-VEELS, Appl. Surf. Sci. 461, 93 (2018)
[15] J. Cañas, G. Alba, D. Leinen, F. Lloret, M. Gutierrez, D. Eon, J. Pernot, E. Gheeraert, D. Araujo, Diamond/γ-alumina band offset determination by XPS, Appl. Sur. Sci. 535, 146301 (2021), https://doi.org/10.1016/j.apsusc.2020.146301
[16] F. Lloret, D. Eon, E. Bustarret, A. Fiori and D. Araujo, Boron-Doping Proximity Effects on Dislocation Generation during Non-Planar MPCVD Homoepitaxial Diamond Growth, Nanomaterials 8, 480 (2018); doi:10.3390/nano8070480 // D. Araujo, F. Lloret, G. Alba, M. P. Alegre, and M. P. Villar, Dislocation generation mechanisms in heavily boron-doped diamond epilayers, Appl. Phys. Lett. 118, 052108 (2021); https://doi.org/10.1063/5.0031476
[17] J. Cañas et al, MRS Fall Meeting in Boston (November 30, 2021): "1kV Normally OFF Diamond lateral reverse blocking MESFET"
[18] M. Iwataki et al., "Over 12000 A/cm2 and 3.2 m□ cm2 Miniaturized Vertical-Type Two-Dimensional Hole Gas Diamond MOSFET," in IEEE Electron Device Letters, vol. 41, no. 1, pp. 111-114, Jan. 2020, doi: 10.1109/LED.2019.2953693
[19] H. Kawarada et al., "Diamond MOSFETs using 2D hole gas with 1700V breakdown voltage," 2016 28th International Symposium on Power Semiconductor Devices and ICs (ISPSD), 2016, pp. 483-486, doi: 10.1109/ISPSD.2016.7520883.

## Claims

1. Junction field-effect transistor (JFET) for high-power electronics using lateral/selective diamond growth, based on an interdigitated geometry.

2. Junction field-effect transistor (JFET) for high-power electronics by means of lateral/selective diamond growth, according to claim 1, comprising:
a) An electronic-grade and suitably polished diamond substrate (surface roughness ≤1 nm).
b) A first layer of p+ type highly doped semiconducting diamond material.
c) A second layer of low p- doped diamond material.
d) A third layer of low p- doped diamond consisting of a digitated structure.
e) A fourth layer of highly p+-doped diamond that vertically extends the previous digitated structure.
f) A fifth layer of n type doped semiconducting diamond material grown on the slopes of each digitated structure of the previous layer.
g) Etched at their ends, deep enough to reach the first p+ type doped semiconducting diamond layer.

3. Junction field-effect transistor (JFET) for high power using lateral/selective diamond growth, according to claims 1 and 2, making use of monocrystalline diamond as substrate and active material.

4. Diamond junction field-effect transistor (JFET) for high power by means of lateral/selective growth, according to claims 1, 2 and 3, **characterized in that** the second p⁻ diamond layer has an engraving on its surface so that it exhibits an interdigitated structure.

5. Diamond junction field-effect transistor (JFET) for high power by means of lateral/selective growth, according to claims 1, 2, 3 and 4, wherein the first layer, of p⁺ semiconductor diamond, has a boron concentration in the range 10¹⁷<[B]<10²⁴ cm^{-3.}

6. Diamond junction field-effect transistor (JFET) for high power by means of lateral/selective growth, according to claims 1, 2, 3, 4 and 5, wherein the second and third p⁻ diamond layers have a boron concentration in the range 10¹⁵<[B]<10¹⁷cm⁻³.

7. Diamond junction field-effect transistor (JFET) for high power by means of lateral/selective growth, according to claims 1, 2, 3, 4, 5 and 6, wherein the fourth layer, of p⁺ semiconductor diamond, has a boron concentration in the range 10¹⁷<[B]<10²⁴ cm⁻³

8. Diamond junction field-effect transistor (JFET) for high power by means of lateral/selective growth, according to claims 1, 2, 3, 4, 5, 6 and 7, the fifth layer of which, of n type doped diamond, is deposited in the spacing between the digits of p⁻/p⁺ diamond material.

9. Diamond junction field-effect transistor (JFET) for high power by means of lateral/selective growth, according to claims 1, 2, 3, 4, 5, 6, 7 and 8, whose drain contacts are made on the first p⁺ type diamond layer, the source contacts are made on the digits of the last p⁺ type diamond layer and the gate contacts are made on the n type diamond layer, but in none of the cases do they have to be limited to occupying those layers.

10. Method for manufacturing a diamond junction field-effect transistor (JFET), according to claims 1 to 9, carried out on a suitably polished, electronic-grade diamond substrate, comprising the following steps:
a) Growth of a first layer of p, p⁺ type doped diamond.
b) Growth of a second layer of p, p⁻ type non-doped diamond.
c) Growth of a third layer of p, p⁺ doped diamond.
d) Etching of the second and third diamond layers with digitated structures.
e) Selective growth of an n-doped diamond layer between the walls of the digitated structures.
f) Etching in regions outside the three-dimensional structure that reach the first grown p⁺ layer.

11. Manufacturing method for a diamond junction field-effect transistor (JFET), according to claims 1 to 9, carried out on a suitably polished, electronic-grade diamond substrate, comprising the following steps:
a) Growth of a first layer of p, p⁺ doped diamond.
b) Growth of a second layer of p, p⁻ non-doped diamond.
c) Selective mask growth of a third layer of p, p⁻doped diamond, forming a digitated structure.
d) Selective mask growth of a fourth layer of p, p⁺ doped diamond, over the previous layer, vertically extending the digitated structure.
e) Selective growth of an n type doped diamond layer between the walls of the digitated structures.
f) Etching in regions outside the three-dimensional structure that reach the first p⁺ layer.

12. Manufacturing method for a junction field-effect transistor (JFET), according to claim 10, wherein the growth of the third layer, corresponding to n type doped diamond, is carried out laterally.

13. Manufacturing method for a junction field-effect transistor (JFET), according to claim 11, wherein the growth of the third layer, corresponding to n type doped diamond, is carried out laterally.

14. Manufacturing method for a junction field-effect transistor (JFET), according to claim 10, wherein the growth of the third layer, corresponding to n type doped diamond, is selectively carried out by means of a mask.

15. Manufacturing method for a junction field-effect transistor (JFET), according to claim 11, wherein the growth of the third layer, corresponding to n type doped diamond, is selectively carried out by means of a mask.
